# EUROPEAN PATENT SPECIFICATION

(11) **EP 3 867 971 B1**
(45) Date of publication and mention of the grant of the patent: **23.08.2023**
(21) Application number: 19772715.9
(22) Date of filing: 19.09.2019
(51) Int. Cl.: H01P 5/107, H01Q 3/26, H01Q 21/00

(54) **A CONTACTLESS ANTENNA MEASUREMENT DEVICE**
BERÜHRUNGSLOSE ANTENNENMESSEINRICHTUNG
DISPOSITIF DE MESURE D'ANTENNE SANS CONTACT

(30) Priority: 19.10.2018 SE 1830297; 13.11.2018 SE 1830332
(43) Date of publication of application: 25.08.2021
(73) Proprietor: Gapwaves AB, 414 51 Göteborg (SE)
(72) Inventor: BENCIVENNI, Carlo, 41262 Göteborg (SE); EMANUELSSON, Thomas, 42668 Västra Frölunda (SE); UZ ZAMAN, Ashraf, 42241 Hisings Backa (SE); BJURKLINT, Arvid, 43169 Mölndal (SE)
(74) Representative: Lind Edlund Kenamets Intellectual Property AB
(86) International application number: PCT/EP2019/075097
(87) International publication number: WO 2020/078653

(56) References cited:
- WO-A1-2018/067046
- BRAZALEZ ASTRID ALGABA ET AL: "Design and Validation of Microstrip Gap Waveguides and Their Transitions to Rectangular Waveguide, for Millimeter-Wave Applications", IEEE TRANSACTIONS ON MICROWAVE THEORY AND TECHNIQUES, PLENUM, USA, vol. 63, no. 12, 6 November 2015 (2015-11-06), pages 4035-4050, XP011592652, ISSN: 0018-9480, DOI: 10.1109/TMTT.2015.2495141 [retrieved on 2015-12-02]
- RAHIMINEJAD SOFIA ET AL: "Polymer Gap Adapter for Contactless, Robust, and Fast Measurements at 220-325 GHz", JOURNAL OF MICROELECTROMECHANICAL SYSTEMS, IEEE SERVICE CENTER, US, vol. 25, no. 1, 1 February 2016 (2016-02-01), pages 160-169, XP011597857, ISSN: 1057-7157, DOI: 10.1109/JMEMS.2015.2500277 [retrieved on 2016-02-01]
- RAHIMINEJAD S ET AL: "Micromachined contactless pin-flange adapter for robust high-frequency measurements", JOURNAL OF MICROMECHANICS & MICROENGINEERING, INSTITUTE OF PHYSICS PUBLISHING, BRISTOL, GB, vol. 24, no. 8, 22 July 2014 (2014-07-22), page 84004, XP020268128, ISSN: 0960-1317, DOI: 10.1088/0960-1317/24/8/084004 [retrieved on 2014-07-22]
- SEO K ET AL: "Microstrip-to-waveguide transition using waveguide with large broad-wall in millimeter-wave band", ULTRA-WIDEBAND (ICUWB), 2010 IEEE INTERNATIONAL CONFERENCE ON, IEEE, PISCATAWAY, NJ, USA, 20 September 2010 (2010-09-20), pages 1-4, XP031783980, ISBN: 978-1-4244-5305-4

## Description

### TECHNICAL FIELD

The present disclosure relates to wireless transmission systems in general, and to measurement equipment for antenna characterization in particular. There are disclosed arrangements and equipment which facilitate measurements of antenna characteristics.

### BACKGROUND

Wireless communication networks comprise radio frequency transceivers, such as radio base stations used in cellular access networks, microwave radio link transceivers used for, e.g., backhaul into a core network, and satellite transceivers which communicate with satellites in orbit.

A radar transceiver is also a radio frequency transceiver since it transmits and receives radio frequency signals.

Radio transceivers, in general, comprise antenna devices. There is often one radio branch connected to the antenna device arranged for transmission, and another radio branch connected to the antenna device arranged for reception.

It is important to be able to determine antenna characteristics, such as radiated power before and sometimes also during operation. Antenna characterization techniques refers to the evaluation of antenna performance and testing of antennas to ensure that the antenna meets specifications. Typical parameters for characterization of antennas are, e.g., antenna gain, transmitter output power, power distribution over an antenna array, noise figure, gain-settings, and the like.

Several antenna characterization techniques are known, e.g., far-field techniques and near-field techniques. Far field techniques involve antenna measurements using measurement antennas deployed in the antenna under test (AUT) far field (a distance significantly larger compared to the operation wavelength) so as not to disturb antenna radiation properties. Due to the size required to create a far-field range for large antennas, near-field techniques were developed, which allow the measurement of the field on a surface close to the antenna, i.e., typically 3 to 10 times the operation wavelength. This measurement is then predicted to be the same as far field characterization. A third common method is the compact range, which uses a reflector to create a field near the AUT that looks approximately like a plane-wave.

Known antenna measurement techniques are costly and often require large footprint measurement facilities.

At higher frequencies, antennas become rather small in size, which increases the requirements on mechanical precision. The dynamic range of measurable powers also become more challenging at higher frequencies, as it becomes more demanding and costly to generate high powers at high frequencies.

Astrid Algaba Brazalez et. al.: "Design and Validation of Microstrip Gap Waveguides and Their Transitions to Rectangular Waveguide, for Millimeter-Wave Applications", IEEE TRANSACTIONS ON MICROWAVE THEORY AND TECHNIQUES, PLENUM, USA, vol. 63, no. 12, 6 November 2015 (2015-11-06), pages 4035-4050, discloses a microstrip to waveguide transition.

Sofia Rahimineiad et. al.: "Polymer Gap Adapter for Contactless, Robust, and Fast Measurements at 220-325 GHz", JOURNAL OF MICROELECTROMECHANICAL SYSTEMS, IEEE SERVICE CENTER, US, vol. 25, no. 1, 1 February 2016 (2016-02-01), pages 160-169, discloses a metamaterial-based waveguide flange adapter.

There is a need for improved antenna measurement techniques and equipment which simplify antenna characterization, especially at higher carrier frequencies.

### SUMMARY

It is an object of the present disclosure to provide a measurement device for measuring antenna characteristics of an antenna under test (AUT). The AUT has a radiating element through which the AUT transmits and/or receives electromagnetic signals, such as radar and radio signals. The measurement device comprises an exterior surface wherein a measurement aperture is formed. A repetitive structure is arranged on the exterior surface. The repetitive structure comprises a plurality of protruding conductive elements arranged to surround the measurement aperture and to define a passage into the measurement aperture. The repetitive structure is configured to attenuate electromagnetic signal propagation past the repetitive structure, in a given frequency band, while allowing electromagnetic signal propagation via the passage

This way antenna characteristics of the AUT can be measured with high accuracy and low cost. There is no need for expensive measurement probes or anechoic chambers, since the measurements are performed via coupling between the AUT radiating element and the measurement aperture. Furthermore, the close proximity of the AUT and the measurement aperture reduces the required transmitted power level of the AUT, which is an advantage.

According to aspects, the measurement device is arranged to engage the AUT such that the measurement apertures are aligned with and face the radiating elements, whereby the passage constitutes an electromagnetically sealed passage between the radiating elements and measurement apertures.

Requirements on mechanical precision are relaxed by the disclosed techniques, since the electromagnetic sealing of the passage does not require electrical contact between AUT and measurement device, which is an advantage.

According to aspects, a plurality of measurement apertures is formed in the exterior surface surrounded by respective repetitive structures. Each such measurement aperture is arranged to align with a respective radiating element on the AUT when the measurement device engages the AUT.

This way antenna characteristics of antenna arrays comprising a plurality of radiating elements can be efficiently and conveniently characterized in a cost-effective manner by a single measurement device.

According to aspects, the measurement aperture comprises a slot aperture configured in dependence of a radiating element shape of the AUT.

By adapting the shape of the slot aperture in the measurement device to the AUT radiating element, an improved matching can be obtained between radiating element and measurement aperture. This is an advantage, e.g., since measurement accuracy is increased.

According to aspects, an antenna aperture such as a slot antenna aperture or other waveguide aperture constitutes the radiating element.

The measurement device is particularly suited for characterization of slot antenna devices. The characterization can be performed in a contactless manner, which is an advantage.

According to other aspects, a patch antenna element constitutes the radiating element. Consequently, the antenna measurement device can be used with both slot antennas and patch antennas, or a combination thereof, which is an advantage.

According to aspects the exterior surface, the measurement aperture, and the repetitive structure are integrally formed from a single metal element.

This way of realization yields a mechanically robust measurement device obtainable at low cost.

According to aspects, the repetitive structure is arranged releasably attached to the exterior surface.

It is appreciated that the geometry of the repetitive structure depends on the frequency band of operation. For instance, the size and spacing of the protruding elements are preferably adapted to the frequency band of operation. The measurement device can, however, be adapted to operate in different frequency bands by selecting the repetitive structure to match the current frequency band of operation. A kit of different repetitive structures can be supplied with the measurement device, which enables convenient replacement of the repetitive structure as needed for different frequency bands of operation.

According to aspects, a first protruding element is arranged on the exterior surface and configured to engage with a respective first recess formed on the AUT, thereby providing means for aligning the measurement aperture with the radiating element when the measurement device engages the AUT, which is an advantage. As a complement or alternative, the protruding element can be arranged on the AUT instead and the corresponding recess on the measurement device.

According to aspects, the measurement device comprises a front section and a back section. The front section comprises the exterior surface and the repetitive structure. The back section comprises at least one ridge structure or other signal conduit arranged communicatively coupled with respective measurement apertures formed in the exterior surface.

This way different front sections can be used to fit different AUT geometries. The back section can be re-used, which is an advantage.

There are also disclosed herein measurement devices comprising measurement circuitry, measurement equipment, and methods associated with the above-mentioned advantages.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated. Further features of, and advantages with, the present invention will become apparent when studying the appended claims and the following description. The skilled person realizes that different features of the present invention may be combined to create embodiments other than those described in the following, without departing from the scope of the present invention.

### BRIEF DESCRIPTION OF THE DRAWINGS

The present disclosure will now be described more in detail with reference to the appended drawings, where:
- Figure 1: schematically shows an antenna measurement device;
- Figure 2: shows an example of an AUT;
- Figure 3: shows a measurement device about to engage an AUT;
- Figure 4: schematically illustrates a measurement device;
- Figure 5: shows a measurement device about to engage an AUT;
- Figure 6: schematically illustrates a measurement device;
- Figure 7A: shows a measurement device about to engage an AUT;
- Figure 7B: shows a measurement device engaging an AUT; and
- Figure 8: is a flowchart illustrating methods.

### DETAILED DESCRIPTION

The invention will now be described more fully hereinafter with reference to the accompanying drawings, in which certain aspects of the invention are shown. This invention may, however, be embodied in many different forms and should not be construed as limited to the embodiments and aspects set forth herein; rather, these embodiments are provided by way of example so that this disclosure will be thorough and complete, and will fully convey the scope of the invention to those skilled in the art. Like numbers refer to like elements throughout the description.

Herein, the term waveguide refers to a metallized tubular structure unless otherwise explicitly noted. For instance, the metallized tubular structure may be a circular, elliptical or rectangular cross-section waveguide. A waveguide may also refer to other known waveguide structures, such as arrangements comprising a ridge, a double ridge, or the like. A waveguide is an example of a signal conduit.

The term microstrip herein denotes a planar transmission medium in general. Thus, for instance, strip-lines and the like are included when referring to microstrips unless otherwise noted. A microstrip is an example of a signal conduit.

Antenna characteristics refer to one or more antenna properties. Examples of antenna characteristics comprise antenna gain, output power, system output power including transmitter, output power distribution over an antenna surface, noise figure, gain-settings, output signal phase compared to an absolute reference phase or to another output signal, and the like.

Antenna characteristics may also comprise properties of a transceiver system including the AUT. Thus, characterizing an antenna may comprise determining output power of a transmission system comprising an antenna and one or more transmission branches.

Other relevant parameters for characterization of antennas are, e.g., radiation patterns, beam-widths, polarizations, and impedances.

As communication frequency bands go higher and higher, transmission components become smaller and smaller. This is because the size of many components, such as waveguides and filters are determined in proportion to a wavelength of the carrier frequency. This complicates manufacturing of transmission components since higher and higher mechanical precision is required in order to obtain satisfactory performance.

A central concept herein is the use of repetitive structures for attenuating electromagnetic fields. Such repetitive structures are often referred to as 'gap waveguide structures' in the literature. A gap waveguide is generally built up of two parts; a structured metal or conductive surface and a flat metal or conductive surface being placed in close proximity to one another, but not necessarily in direct contact. The structured surface is characterized by pins or other protrusions forming a metamaterial surface sometimes referred to as an artificial magnetic conductor. The protrusions create a barrier preventing the electromagnetic waves from propagating in undesired directions. In this way, the pins replace the walls in rectangular waveguides. This is done without requiring a perfectly sealed metallic or conductive enclosure, which is an advantage since requirements on mechanical precision are reduced. Gap waveguide structures, and methods to configure them with geometrical properties to attenuate electromagnetic signal propagation in a given frequency band are known and will not be discussed in more detail here. One method to determine a suitable repetitive structure geometry for a given frequency band is by computer simulation, possibly in addition to mathematical analysis.

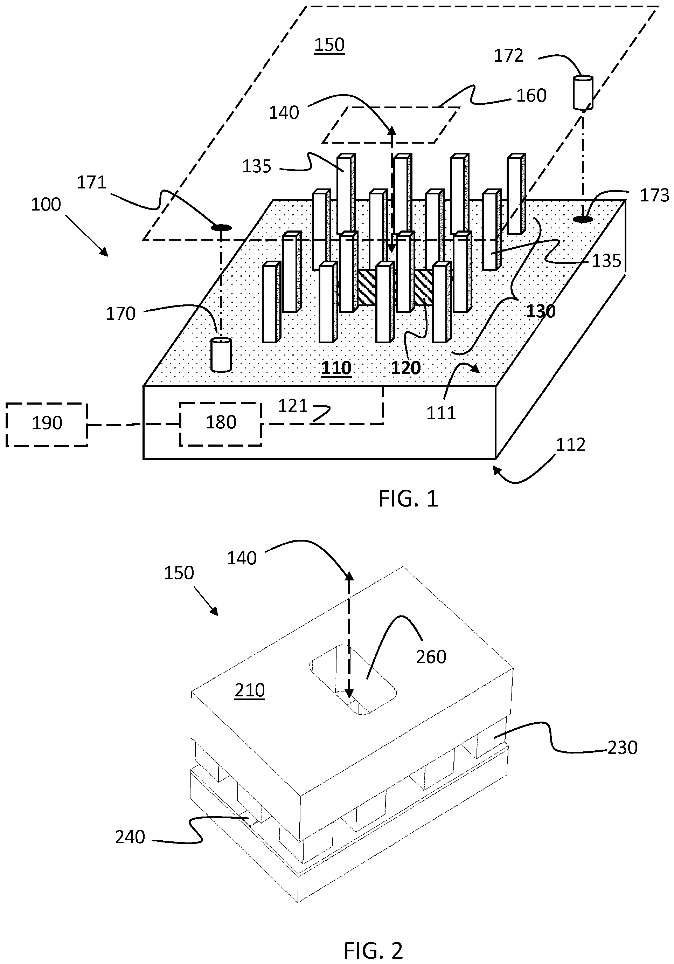

Figure 1 schematically illustrates a measurement device 100 for measuring antenna characteristics of an antenna under test 150, AUT. The AUT has a radiating element 160. The measurement device 100 comprises an exterior surface 110, where a measurement aperture 120 is formed in the exterior surface, and a repetitive structure 130 is arranged on the exterior surface. The repetitive structure 130 is not drawn to any particular scale, but only schematically illustrated as appreciated by the skilled person. The repetitive structure 130 comprises a plurality of protruding conductive elements 135 arranged to surround the measurement aperture 120 and to define a passage 140 into the measurement aperture 120. The repetitive structure 130 is configured to attenuate electromagnetic signal propagation in a frequency band past the repetitive structure 130 while allowing electromagnetic signal propagation via the passage 140, at least when the measurement device engages the AUT. Notably, the repetitive structure is arranged on the outside of the measurement device and forms a gap waveguide structure when engaging the AUT. In other words, the measurement device comprises one end of a gap waveguide structure, which is completed by the AUT.

It is appreciated that reciprocity holds for devices like the measurement device illustrated in Figure 1. This means that the device can be used to receive emissions from an AUT as well as to excite an AUT, i.e., transmit radio frequency signals to be received by the AUT. Measurements can therefore be made in both transmit and receive direction, which is an advantage. It is also appreciated that measurement can be made including receive or transmit circuitry connected to, or integrated in, the AUT.

The measurement device 100 is arranged to engage the AUT 150 such that the measurement aperture 120 is aligned with and faces the radiating element 160, whereby the passage 140 constitutes an electromagnetically sealed passage between the radiating element 160 and the measurement aperture 120.

Referring back to the discussion above on gap waveguides; the protruding elements 135 together with a ground plane of the AUT 150, which is almost always comprised in the AUT, constitute the two parts of a gap waveguide structure. The protruding elements make up the structured conductive surface which is placed in close proximity to the ground plane metal surface of the AUT. Here, close proximity means that the distance is smaller than approximately a quarter of the operation wavelength, i.e., a wavelength corresponding to an approximate carrier frequency of the electromagnetic signals in the frequency band of the measurement operation. It is appreciated that the repetitive structure of protrusions is a periodic or quasi-periodic structure. Consequently, the protrusions create a barrier preventing the electromagnetic waves from propagating in undesired directions. The dimensions of the protruding element and their relative configuration determine the frequency dependent attenuation properties of the repetitive structure. Here, the undesired directions are the directions leading away from the passage 140 which originates at the measurement aperture 120 and leads to the radiating element 160 when the measurement device 100 engages the AUT 150. Thus, the repetitive structure 130 is configured to attenuate electromagnetic signal propagation in a frequency band past the repetitive structure while allowing propagation via the passage 140.

It is appreciated that the protruding elements can be metal elements or metallized conductive elements. However, some polymers and the like are also conductive, which means that they can be used to form the protruding conductive elements.

According to some aspects, as exemplified in Figure 1, the repetitive structure 130 is a pin structure comprising conductive pins, e.g., metal or metalized pins, arranged periodically protruding from a conducting plane comprised in the measurement device. The conducting plane may, e.g., be the exterior surface or some other plane arranged below the exterior surface. The conducting pins may, e.g., be formed as rectangular or cylindrical protrusions. However, it is realized that many different shapes can be used with similar effect. For instance, mushroom-type protrusions or conical shape protrusions can also be used with the same or similar effect. The respective structure may for instance be milled or otherwise machined from the same piece of metal that make up the exterior surface.

According to some aspects, the exterior surface 110, the measurement aperture 120, and the repetitive structure 130 are integrally formed from a single metal element, i.e., machined or molded from a single piece of metal, or from a single piece of material, such as Polytetrafluoroethylene (PTFE), which then has been metallized.

However, the repetitive structure 130 need not necessarily be integrally formed with the conductive material forming the exterior surface. For instance, according to some aspects, the repetitive structure 130 is configured on a separate carrier assembled with the measurement device. In other words, the repetitive structure 130 is arranged releasably attached to the exterior surface 110.

The separate carrier may, e.g., be a piece of normal plastic material, a dielectric material, a polymer material, or PTFE which is a synthetic fluoropolymer of tetrafluoroethylene. PTFE is a preferred option since it can be molded with high precision to form the protrusions and to fit into a machined grove or recess formed in connection to the measurement device. The insert can be metallized if it is not already formed in a conductive material, thus forming the repetitive structure configured to attenuate electromagnetic signal propagation in a frequency band past the repetitive structure while allowing propagation via the passage 140.

An advantage of using a separate carrier for the repetitive structure is that the dimensions of the repetitive structure can be selected based on application, while the other parts of the measurement device can be re-used, at least if a bushing member is configured in the measurement aperture to form the correct size aperture for the frequency band of operation. So, according to some aspects, the measurement device 100 comprises a kit of repetitive structures arranged to attenuate electromagnetic signal propagation in respective frequency bands.

Optionally, to improve alignment between measurement aperture and radiating element, one or more alignment holes 171,173 may be configured to receive respective alignment taps 170, 172 soldered to the measurement device and/or to the AUT. The soldering process is associated with a self-alignment effect; During assembly on a PCB or the like, first solder paste is deposited on pads arranged with high mechanical precision the PCB. In a second step surface mounted components are placed on the pads. The third step is a re-melting of the solder, where the solder joints are formed. During re-melting, forces from surface tension and capillary effects acts on the surface mounted component to align the component with the older pads on the PCB. Thus, soldered alignment taps can be expected to be placed with high accuracy relative to the patch antenna on the PCB. It is appreciated that a single alignment tap provides one fixed point, i.e., the PCB may then rotate in relation to the waveguide module. Two or more alignment taps with respective holes machined in the waveguide module will fix the measurement device 100 relative to the AUT.

In other words, according to some aspects, a first protruding element 170 is arranged on the exterior surface 110 and configured to engage with a respective first recess 171 formed on the AUT 150, thereby providing means for aligning the measurement aperture 120 with the radiating element 160 when the measurement device engages the AUT.

According to some other aspects, a second protruding element 172 is arranged on the AUT 150 and configured to engage with a respective second recess 173 arranged on the exterior surface 110, thereby providing means for aligning the measurement aperture 120 with the radiating element 160.

Since different AUTs can have different geometries in terms of, e.g., radiating element location and shape, the measurement device 100 may need different shapes to fit different AUT geometries. So, according to some aspects, the measurement device 100 comprises a front section and at least one back section, the front section comprising the exterior surface 110 and the repetitive structure 130, the back section comprising at least one ridge structure or other signal conduit arranged communicatively coupled with respective measurement apertures formed in the exterior surface.

According to some aspects, the measurement aperture 120 is communicatively coupled 121 to respective measurement circuitry 180. In some applications, it may be beneficial to have measurement circuitry permanently coupled to the measurement aperture. The measurement circuitry could be, for example, a down-converting mixer, which could reduce the complexity of required measurement analysis units.

The AUT can be characterized in different ways by connecting different measurement analysis units to the measurement device. For instance, total radiated power could be measured if a power meter is connected to the measurement device. So, according to some aspects, a measurement analysis unit 190 is connected to one or more measurement devices 100.

Figure 2 shows an example AUT. This AUT comprises a slot aperture 260 which is arranged to be fed via a microstrip line 240 terminated in a patch antenna (not shown in Figure 2). The transition via patch antenna and slot aperture, or tubular waveguide, is sealed by another repetitive structure comprising protruding elements 230 in much the same way as the coupling between the AUT radiating element and the measurement aperture is sealed by the repetitive structure 130. The exterior surface 210 of the AUT is conductive and therefore provides the ground plane for the gap waveguide formed together with the repetitive structure 130 of the measurement device 100. The passage 140 between the radiating element 260 and the measurement aperture 120 is shown by a dashed arrow.

It is thus appreciated that the radiating element 160 of the AUT may according to some aspects be an antenna aperture. The antenna aperture may have different shapes, e.g., a slot antenna aperture.

According to some aspects, the measurement aperture 120 comprises a slot aperture configured in dependence of a radiating element shape of the AUT. For instance, the shape of the measurement aperture may be matched against the shape of the AUT slot shape.

It is appreciated that the measurement device 100 shown in, e.g., Figure 1, can be arranged to engage with the AUT shown in Figure 2. The repetitive structure 130 then forms the above-mentioned seal surrounding the antenna aperture 260 while allowing signal propagation via the passage 140.

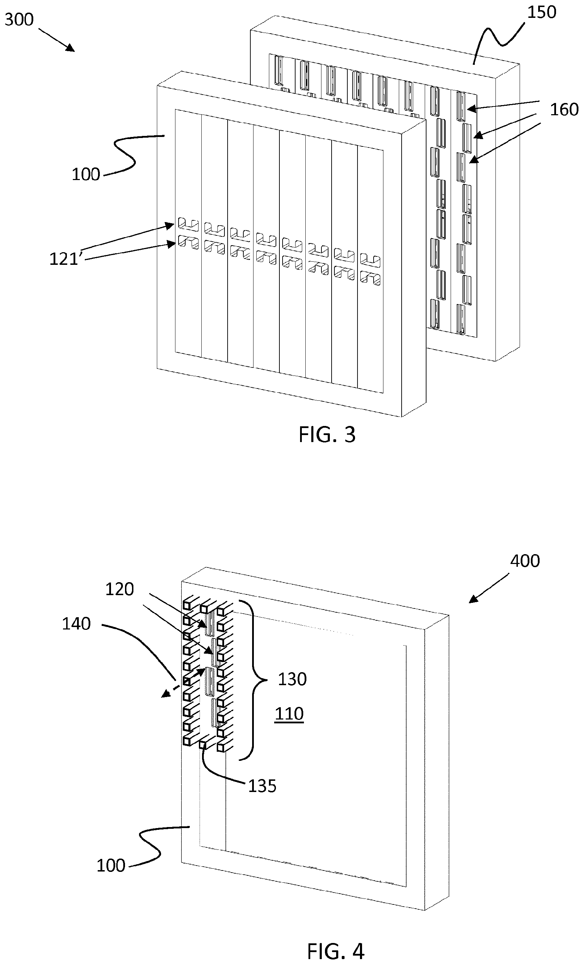

Figure 3 shows a larger measurement device 100 about to engage an AUT 150. In this example a plurality of measurement apertures is formed in the exterior surface 110 surrounded by respective repetitive structures (not shown in Figure 3). Each measurement aperture is arranged to align with a respective radiating element 160 on the AUT when the measurement device engages the AUT. The radiating elements 160 may be arranged as sub-array apertures, in which case measurement apertures have a corresponding sub-array configuration.

Figure 3 shows waveguide apertures 121', which constitute means for communicatively coupling the measurement apertures to respective measurement circuitry 180 (not shown in Figure 3).

Figure 4 schematically illustrates a measurement device which comprises a single sub-array measurement aperture having a plurality of slots. The repetitive structure is arranged to surround the sub-array. The measurement device in Figure 4 may be used to single out a sub-array in an AUT such as the AUT illustrated in Figure 3. In this case, a sub-array comprising the four slots from the top in the rightmost column are singled out by the measurement device. The other sub-apertures are isolated by the repetitive structure 130.

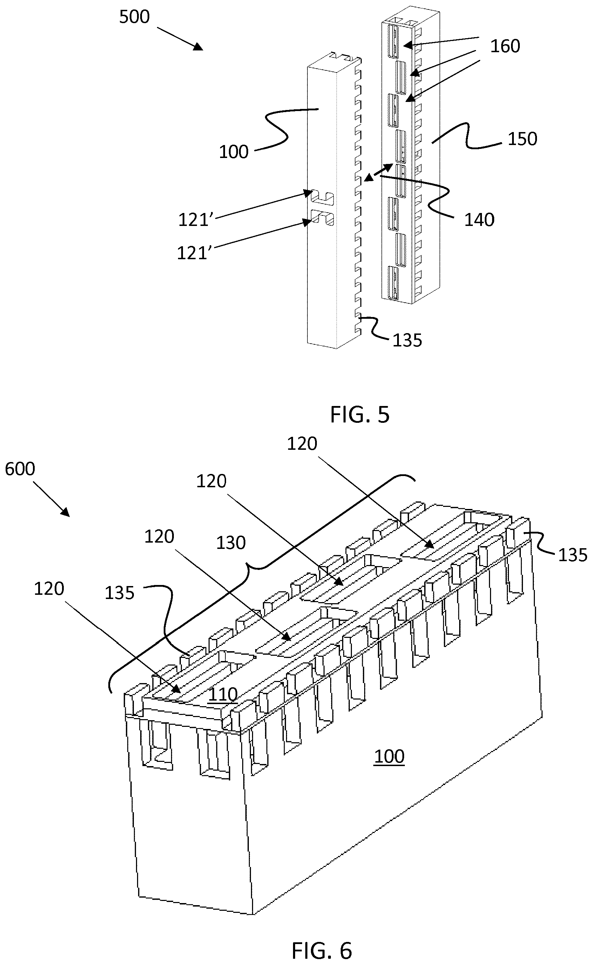

Figure 5 shows a measurement device about to engage an AUT. This measurement device is adapted to measure characteristics of a single column AUT illustrated in Figure 5. The repetitive structure can be seen arranged on the exterior surface along an outer rim of the measurement device.

Figure 6 schematically illustrates a part of a measurement device 100. The measurement aperture here comprises slots forming a sub-array surrounded by a pin structure, which is a repetitive structure 130. The measurement device may, e.g., engage a portion of the AUT shown in Figure 3, thereby allowing for characterization of sections of the AUT, such as individual sub-arrays of the AUT. The measurement device may then be moved around for a complete characterization of the larger AUT structure.

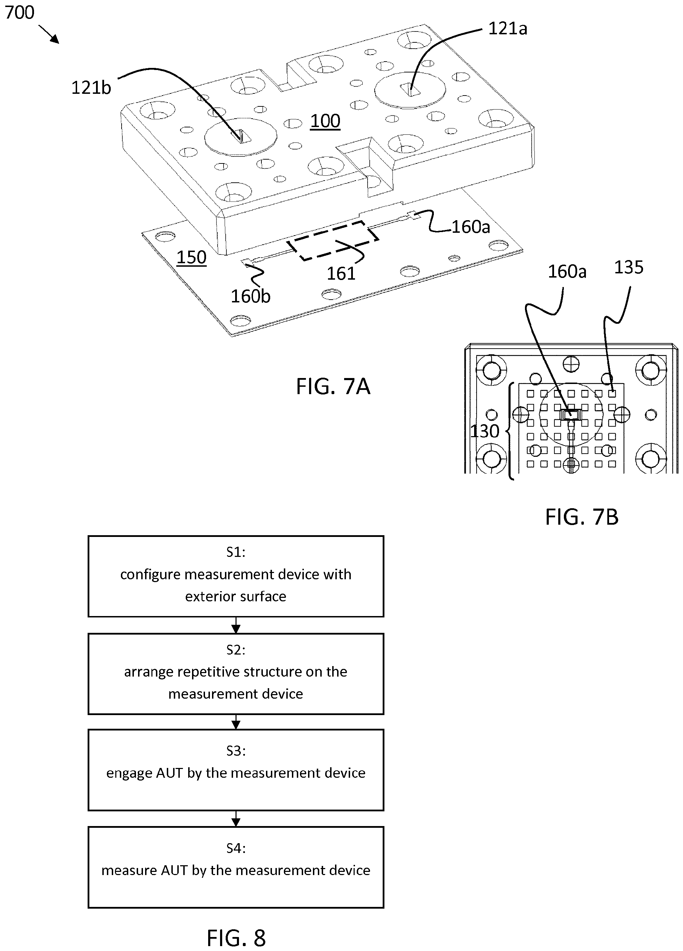

It has already been mentioned that the measurement devices disclosed herein can be used to measure and to characterize other radiating elements than slot apertures. Figure 7A shows one such example measurement device about to engage an AUT comprising two patch antennas 160a, 160b. A circuit 161, such as a radio transceiver or radar transceiver, or other integrated circuit, is shown arranged on the AUT 150 and connected to the patch antennas 160a, 160b. Consequently, according to some aspects, a patch antenna element constitutes the radiating element 160.

Figure 7B shows a top view of the measurement device from Figure 7A when it is engaging the AUT. A repetitive structure 130 is shown surrounding the measurement aperture which is aligned with the patch antenna 160a. Consequently, there is a passage formed between the patch antenna 160a and the corresponding measurement aperture.

According to some aspects, the combination of measurement device and AUT constitutes a waveguide transition from a radiating element in the form of a patch antenna to a waveguide structure.

Figure 8 is a flowchart illustrating methods. There is illustrated a method for measuring antenna characteristics of an antenna under test 150, AUT, the AUT having a radiating element 160, the method comprises;
configuring S1 the measurement device 100 with an exterior surface 110, where a measurement aperture 120 is formed in the exterior surface;
arranging S2 a repetitive structure 130 on the exterior surface, wherein the repetitive structure 130 comprises a plurality of protruding conductive elements 135 arranged to surround the measurement aperture 120 and to define a passage 140 into the measurement aperture 120, the repetitive structure 130 being configured to attenuate electromagnetic signal propagation in a frequency band past the repetitive structure 130 while allowing propagation via the passage 140;
engaging S3 the AUT by the measurement device 100 such that the measurement aperture is aligned with and faces the radiating element, whereby the passage 140 constitutes an electromagnetically sealed passage between the radiating element 160 and the measurement aperture 120); and
measuring S4 antenna characteristics of the AUT 150 by the measurement device 100.

Thus, the method describes aspects of the above disclosed techniques for measuring antenna characteristics by the disclosed measurement devices.

## Claims

1. A measurement device (100) for measuring antenna characteristics of an antenna under test (150), AUT, the AUT having a plurality of radiating elements (160), the measurement device (100) comprising an exterior surface (110), where a plurality of measurement apertures (120) is formed in the exterior surface, and a repetitive structure (130) is arranged on the exterior surface, the repetitive structure (130) comprising a plurality of protruding conductive elements (135) arranged to surround the plurality of measurement apertures (120) and to define a passage (140) into the measurement apertures (120), wherein each measurement aperture is arranged to align with a respective radiating element on the AUT (150) when the measurement device engages the AUT, the repetitive structure (130) being configured to attenuate electromagnetic signal propagation past the repetitive structure (130), in a given frequency band, while allowing electromagnetic signal propagation via the passage (140).

2. The measurement device (100) according to any previous claim, wherein each measurement aperture is surrounded by respective repetitive structures.

3. The measurement device (100) according to any previous claim, wherein the plurality of measurement apertures is arranged in a subarray in the exterior surface (110), wherein the subarray is surrounded by the repetitive structure .

4. The measurement device (100) according to any previous claim, wherein a measurement aperture comprises a slot aperture configured in dependence of a radiating element shape of the AUT.

5. The measurement device (100) according to any previous claim, wherein the exterior surface (110), the measurement aperture (120), and the repetitive structure (130) are integrally formed from a single metal element.

6. The measurement device (100) according to any of claims 1-3, wherein the repetitive structure (130) is arranged releasably attached to the exterior surface (110).

7. The measurement device (100) according to any previous claim, wherein a first protruding element (170) is arranged on the exterior surface (110) and configured to engage with a respective first recess (171) formed on the AUT (150), thereby providing means for aligning the measurement aperture (120) with the radiating element (160) when the measurement device engages the AUT.

8. The measurement device (100) according to any previous claim, wherein the plurality of protruding conductive elements (135) comprise one or more metal or metallized elements, or one or more conductive polymer elements, or any combination thereof.

9. Measurement equipment comprising a measurement analysis unit (190) connected to one or more measurement devices (100) according to any of the previous claims.

10. A method for measuring antenna characteristics of an antenna under test (150), AUT, the AUT having a plurality of radiating elements (160), the method comprising;
configuring (S1) the measurement device (100) with an exterior surface (110), where a plurality of measurement apertures (120) is formed in the exterior surface;
arranging (S2) a repetitive structure (130) on the exterior surface, wherein the repetitive structure (130) comprises a plurality of protruding conductive elements (135) arranged to surround the plurality of measurement apertures (120) and to define a passage (140) into the measurement apertures (120), the repetitive structure (130) being configured to attenuate electromagnetic signal propagation in a frequency band past the repetitive structure (130) while allowing propagation via the passage (140);
engaging (S3) the AUT by the measurement device (100) such that the measurement apertures are aligned with and facing respective radiating elements, whereby the passage (140) constitutes an electromagnetically sealed passage between the radiating elements (160) and the measurement apertures (120); and measuring (S4) antenna characteristics of the AUT (150) by the measurement device (100).

## Patentansprüche

1. Messvorrichtung (100) zum Messen von Antenneneigenschaften einer Prüfantenne (150), AUT, die AUT aufweisend mehrere abstrahlende Elemente (160), die Messvorrichtung (100) aufweisend eine Außenfläche (110), wobei mehrere Messöffnungen (120) in der Außenfläche gebildet sind und eine sich wiederholende Struktur (130) an der Außenfläche angeordnet ist, die sich wiederholende Struktur (130) aufweisend mehrere vorspringende leitfähige Elemente (135), die angeordnet sind, die mehreren Messöffnungen (120) zu umschließen und einen Durchgang (140) in die Messöffnungen (120) zu definieren, wobei jede Messöffnung angeordnet ist, sich an einem jeweiligen ausstrahlenden Element an der AUT (150) auszurichten, wenn die Messvorrichtung in die AUT eingreift, wobei die sich wiederholende Struktur (130) eingerichtet ist, elektromagnetische Signalweiterleitung an der sich wiederholenden Struktur (130) vorbei in einem bestimmten Frequenzband zu dämpfen, während elektromagnetische Signalweiterleitung über den Durchgang erlaubt wird (140).

2. Messvorrichtung (100) nach einem der vorhergehenden Ansprüche, wobei jede Messöffnung durch jeweilige sich wiederholende Strukturen umschlossen ist.

3. Messvorrichtung (100) nach einem der vorhergehenden Ansprüche, wobei die mehreren Messöffnungen in einem Unterarray in der Außenfläche (110) angeordnet sind, wobei das Unterarray von der sich wiederholenden Struktur umschlossen ist.

4. Messvorrichtung (100) nach einem der vorhergehenden Ansprüche, wobei eine Messöffnung eine Schlitzöffnung aufweist, die abhängig von einer Form des abstrahlenden Elements der AUT eingerichtet ist.

5. Messvorrichtung (100) nach einem der vorhergehenden Ansprüche, wobei die Außenfläche (110), die Messöffnung (120) und die sich wiederholende Struktur (130) integral aus einem einzigen Metallelement gebildet sind.

6. Messvorrichtung (100) nach einem der Ansprüche 1 bis 3, wobei die sich wiederholende Struktur (130) trennbar an der Außenfläche (110) befestigt angeordnet ist

7. Messvorrichtung (100) nach einem der vorhergehenden Ansprüche, wobei ein erstes vorspringendes Element (170) an der Außenfläche (110) angeordnet und eingerichtet ist, in einen jeweiligen ersten Ausschnitt (171) einzugreifen, der an der AUT (150) gebildet ist, dadurch Mittel zum Ausrichten der Messöffnung (120) an dem abstrahlenden Element (160) bereitstellend, wenn die Messvorrichtung in die AUT eingreift.

8. Messvorrichtung (100) nach einem der vorhergehenden Ansprüche, wobei die mehreren vorspringenden leitfähigen Elemente (135) ein oder mehrere metallische oder metallisierte Elemente oder ein oder mehrere leitfähige Polymerelemente oder eine beliebige Kombination daraus aufweisen.

9. Messausrüstung, aufweisend eine Messanalyseeinheit (190), die mit einer oder mehreren Messvorrichtungen (100) nach einem der vorhergehenden Ansprüche verbunden ist.

10. Verfahren zum Messen von Antenneneigenschaften einer Prüfantenne (150), AUT, die AUT umfassend mehrere abstrahlende Elemente (160), das Verfahren umfassend
Einrichten (S1) der Messvorrichtung (100) mit einer Außenfläche (110), wobei mehrere Messöffnungen (120) in der Außenfläche gebildet sind;
Anordnen (S2) einer sich wiederholenden Struktur (130) an der Außenfläche, wobei die sich wiederholende Struktur (130) mehrere vorspringende leitfähige Elemente (135) umfasst, die angeordnet sind, die mehreren Messöffnungen (120) zu umschließen und einen Durchgang (140) in die Messöffnungen (120) zu definieren, die sich wiederholende Struktur (130) eingerichtet, um elektromagnetische Signalweiterleitung in einem Frequenzband an der sich wiederholenden Struktur (130) vorbei zu dämpfen, während die Weiterleitung über den Durchgang (140) erlaubt wird;
Eingreifen (S3) in die AUT durch die Messvorrichtung (100), sodass die Messöffnungen an jeweiligen abstrahlenden Elementen ausgerichtet sind und diesen gegenüberliegen, wobei der Durchgang (140) einen elektromagnetisch versiegelten Durchgang zwischen den abstrahlenden Elementen (160) und den Messöffnungen (120) darstellt; und
Messen (S4) von Antenneneigenschaften der AUT (150) durch die Messvorrichtung (100).

## Revendications

1. Dispositif de mesure (100) pour mesurer les caractéristiques d'antenne d'une antenne sous test (150), AUT, l'AUT ayant une pluralité d'éléments rayonnants (160), le dispositif de mesure (100) comprenant une surface extérieure (110), où une pluralité d'ouvertures de mesure (120) est formée dans la surface extérieure, et une structure répétitive (130) est agencée sur la surface extérieure, la structure répétitive (130) comprenant une pluralité d'éléments conducteurs en saillie (135) agencés pour entourer la pluralité d'ouvertures de mesure (120) et pour définir un passage (140) dans les ouvertures de mesure (120), dans lequel chaque ouverture de mesure est agencée pour s'aligner avec un élément rayonnant respectif sur l'AUT (150) lorsque le dispositif de mesure vient en prise avec l'AUT, la structure répétitive (130) étant configurée pour atténuer la propagation du signal électromagnétique au-delà de la structure répétitive (130), dans une bande de fréquence donnée, tout en permettant la propagation du signal électromagnétique via le passage (140).

2. Dispositif de mesure (100) selon une quelconque des revendications précédentes, dans lequel chaque ouverture de mesure est entourée de structures répétitives respectives.

3. Dispositif de mesure (100) selon une quelconque des revendications précédentes, dans lequel la pluralité d'ouvertures de mesure est disposée en un sous-réseau dans la surface extérieure (110), dans lequel le sous-réseau est entouré par la structure répétitive.

4. Dispositif de mesure (100) selon une quelconque des revendications précédentes, dans lequel une ouverture de mesure comprend une ouverture en forme de fente configurée en fonction d'une forme d'élément rayonnant de l'AUT.

5. Dispositif de mesure (100) selon une quelconque des revendications précédentes, dans lequel la surface extérieure (110), l'ouverture de mesure (120) et la structure répétitive (130) sont formées en un seul tenant à partir d'un seul élément métallique.

6. Dispositif de mesure (100) selon une quelconque des revendications 1 à 3, dans lequel la structure répétitive (130) est disposée en étant fixée de manière amovible à la surface extérieure (110).

7. Dispositif de mesure (100) selon une quelconque des revendications précédentes, dans lequel un premier élément en saillie (170) est agencé sur la surface extérieure (110) et configuré pour venir en prise avec un premier évidement respectif (171) formé sur l'AUT (150), en fournissant ainsi des moyens pour aligner l'ouverture de mesure (120) avec l'élément rayonnant (160) lorsque le dispositif de mesure vient en prise avec l'AUT.

8. Dispositif de mesure (100) selon une quelconque des revendications précédentes, dans lequel la pluralité d'éléments conducteurs en saillie (135) comprend un ou plusieurs éléments métalliques ou métallisés, ou un ou plusieurs éléments polymères conducteurs ou n'importe quelle combinaison de ceux-ci.

9. Equipement de mesure comprenant une unité d'analyse de mesure (190) connectée à un ou plusieurs dispositifs de mesure (100) selon une quelconque des revendications précédentes.

10. Procédé de mesure des caractéristiques d'antenne d'une antenne sous test (150), AUT, l'AUT ayant une pluralité d'éléments rayonnants (160), le procédé comprenant de :
configurer (S1) le dispositif de mesure (100) avec une surface extérieure (110), dans lequel une pluralité d'ouvertures de mesure (120) est formée dans la surface extérieure ;
disposer (S2) une structure répétitive (130) sur la surface extérieure, dans lequel la structure répétitive (130) comprend une pluralité d'éléments conducteurs en saillie (135) agencés pour entourer la pluralité d'ouvertures de mesure (120) et pour définir un passage (140) dans les ouvertures de mesure (120), la structure répétitive (130) étant configuré pour atténuer la propagation du signal électromagnétique dans une bande de fréquences au-delà de la structure répétitive (130) tout en permettant la propagation via le passage (140) ;
mettre en prise (S3) l'AUT avec le dispositif de mesure (100) de sorte que les ouvertures de mesure soient alignées avec et en vis-à-vis des éléments rayonnants respectifs, moyennant quoi le passage (140) constitue un passage étanche électromagnétique entre les éléments rayonnants (160) et les ouvertures de mesure (120) ; et
mesurer (S4) les caractéristiques d'antenne de l'AUT (150) par le dispositif de mesure (100).
